# EUROPÄISCHE PATENTANMELDUNG

(11) **EP 1 378 950 A1**
(43) Veröffentlichungstag der Anmeldung: **07.01.2004**
(21) Anmeldenummer: 03006981.9
(22) Anmeldetag: 27.03.2003
(51) Int. Cl.: H01L 43/12, H01F 41/30, G01R 33/09, G01B 7/30

(54) **Verfahren zur Einstellung oder lokalen Veränderung einer Magnetisierung in einer Schicht einer magnetoresistiven Schichtanordnung, Heizstempel zum Aufheizen der magnetoresistiven Schichtanordnung und deren Verwendung**

(30) Priorität: 06.07.2002 DE 10230455
(71) Anmelder: ROBERT BOSCH GMBH, 70442 Stuttgart (DE)
(72) Erfinder: Siegle, Henrik, 71229 Leonberg (DE); Johnson, Andrew, 81245 Muenchen (DE); May, Ulrich, 52064 Aachen (DE)

(57) **Zusammenfassung**

Es wird ein Verfahren zur Einstellung oder lokalen Veränderung der Magnetisierungsrichtung einer ferromagnetischen Schicht einer magnetoresistiven Schichtanordnung (11) mit Hilfe eines Heizstempels (5) vorgeschlagen, wobei die ferromagnetische Schicht über eine antiferromagnetische Schicht stabilisiert ist. Dabei wird die antiferromagnetische Schicht mit dem Heizstempel (5) über eine Schwellentemperatur aufgeheizt, oberhalb derer der Einfluss dieser Schicht auf die Magnetisierungsrichtung der benachbarten ferromagnetischen Schicht verschwindet, die ferromagnetische Schicht dann einem externen Magnetfeld vorgegebener Richtung ausgesetzt, und schließlich die antiferromagnetische Schicht wieder unter die Schwellentemperatur abgekühlt wird. Daneben wird ein Heizstempel (5) mit einem Grundkörper (12) und einer beheizbaren, mit dem Grundkörper (12) verbundenen, an die magnetoresistive Schichtanordnung (11) hinsichtlich ihrer lateralen Dimension angepassten oder dieser ähnlichen Stempelstruktur (13) vorgeschlagen. Der Heizstempel (5) und das vorgeschlagene Verfahren eignen sich vor allem zur Herstellung eines magnetoresistiven, nach dem Spin-Valve-Prinzip arbeitenden Schichtsystems, das eine Mehrzahl von magnetoresistiven Schichtanordnungen (11) mit untereinander zumindest teilweise unterschiedlichen resultierenden Magnetisierungsrichtungen in deren jeweiliger Schicht aufweist, wobei die magnetoresistiven Schichtanordnungen (11) insbesondere in Form einer Wheatstone-Brücke miteinander verschaltet sind.

## Beschreibung

Die Erfindung betrifft ein Verfahren zur Einstellung oder lokalen Veränderung einer resultierenden Magnetisierungsrichtung in einer Schicht einer magnetoresistiven Schichtanordnung, einen Heizstempel zum Aufheizen einer magnetoresistiven Schichtanordnung und die Verwendung des Verfahrens oder des Heizstempels zur Herstellung eines magnetoresistiven, nach dem Spin-Valve-Prinzip arbeiteten Schichtsystems nach der Gattung der unabhängigen Ansprüche.

### Stand der Technik

Aufgrund ihrer überlegenen Widerstandskennlinien bieten magnetoresistive Schichtsysteme nach dem Spin-Valve-Prinzip vor allem in Kraftfahrzeugen interessante Einsatzmöglichkeiten zur Sensierung eines Winkels, einer Stromstärke oder einer Drehzahl. Dazu weisen die Schichtsysteme in der Regel vier, nach Art einer Wheatstone'schen Brückenschaltung miteinander verschaltete magnetoresistive Schichtanordnungen auf, von denen mindestens eine eine aktive magnetoresistive Schichtanordnung ist, d. h. eine die auf der Grundlage des GMR- oder AMR-Effektes ("giant magneto-resistance" bzw. "anisotropic magneto-resistance") arbeitende Schichtanordnung. Die einzelnen magnetoresistiven Schichtanordnungen in einem solchen Schichtsystem sind weiter in der Regel in Draufsicht mäanderförmig mit einer quadratischen oder rechteckigen Grundfläche ausgebildet und weisen eine Abfolge dünner Schichten auf, die ein sogenanntes "Spin-Valve" aufbauen, d.h. eine Schichtabfolge mit einer antiferromagnetischen Schicht, einer ersten ferromagnetischen Schicht, einer nichtmagnetischen Schicht und einer zweiten ferromagnetischen Schicht.

Ein solches "Spin-Valve" mit einer anitferromagnetischen Schicht und einer benachbarten ersten ferromagnetischen Schicht zeigt wegen des an der Grenzfläche zwischen beiden Schichten auftretenden "Exchange-Bias-Effektes" eine um das sogenannte "Exchange-Bias-Feld" verschobene magnetische Hysteresekurve. Der Aufbau einer magnetoresistiven Schichtanordnung in Form eines "Spin-Valve" und deren Verwendung als magnetoresistives Sensorelement ist beispielsweise in DE 198 43 348 A1 ausführlich beschrieben. Insbesondere geht daraus der Schichtaufbau, die Funktion der einzelnen Schichten und die Arbeitsweise eines derartigen Sensorelementes hervor.

Um beispielsweise eine Wheatstone'sche Brückenschaltung mit vier magnetoresistiven Schichtanordnungen erzeugen zu können, ist es erforderlich, die Richtungen der resultierenden Magnetisierung in den jeweils zu den antiferromagnetischen Schichten benachbarten ersten ferromagnetischen Schichten in jedem der Brückenzweige der Wheatstoneschen Brückenschaltung definiert und unabhängig voneinander einstellen zu können. Dies geschieht beispielsweise durch Erwärmung und anschließende Abkühlung der magnetoresistiven Schichtanordnung und insbesondere der darin integrierten antiferromagnetischen Schicht über eine materialspezifische, sogenannte "Blocking-Temperatur" oder Schwellentemperatur in einem von außen angelegten Magnetfeld. Diese Vorgehensweise ist beispielsweise in WO 00/79298 erläutert, wobei das Aufheizen der magnetoresistiven Schichtanordnung zur Einstellung der resultierenden Magnetisierungsrichtung durch Eintrag von Wärme mit Hilfe eines Laserpulses oder durch Beaufschlagen der Schichtanordnung mit einem elektrischen Strom erfolgt.

Aus DE 198 30 344 A1 ist ein weiteres Verfahren bekannt, die Magnetisierung einer Bias-Schicht eines magnetoresistiven Sensorelementes einzustellen , wobei die Bias-Schicht Teil eines AAF-Systems ("artificial-antiferromagnetic-system") ist, das eine Bias-Schicht, einer Flussführungsschicht und eine zwischen diesen angeordnete, beide Schichten antiferromagnetisch koppelnde Kopplungsschicht umfasst. Dort wird das Sensorelement zunächst mit Hilfe pulsartig über das Sensorelement geführter Ströme auf eine vorbestimmte Temperatur aufgeheizt, danach ein magnetisches Einstellfeld angelegt, nachfolgend das Einstellfeld nach einer vorbestimmten Zeit wieder abgeschaltet und schließlich das Sensorelement auf die Ausgangstemperatur abgekühlt. Im Übrigen ist in DE 198 30 344 A1 noch einmal detailliert das Verschalten mehrerer magnetoresistive Schichtanordnungen zu einer Wheatstone'schen Brückenschaltung mit unterschiedlicher Richtung der resultierenden Magnetisierung in den einzelnen Schichtanordnungen erläutert. Daneben enthält diese Schrift detaillierte Angaben zum Schichtaufbau und zur Zusammensetzung der einzelnen Schichten der magnetoresistiven Schichtanordnung.

Aus DE 198 43 350 A1 ist schließlich ein elektronisches Bauelement, insbesondere ein Chipelement, bekannt, das wenigstens ein auf einem Substrat angeordnetes magnetoresistives Element aufweist, welches eine Sensorfunktion erfüllt, und wenigstens ein auf dem Substrat angeordnetes magnetoresistives Element, welches eine Speicherfunktion erfüllt. Auch dort ist beschrieben, dass durch Strombeaufschlagung von Leiterbahnen, die unter oder über den magnetoresistiven Schichtanordnungen bzw. Elementen verlaufen, die Magnetisierungsrichtungen der einzelnen Schichten der Elemente parallel oder antiparallel zueinander ausrichtbar ist.

Aufgabe der vorliegenden Erfindung war, eine weitere Möglichkeit bereitzustellen, in einer Schicht einer magnetoresistive Schichtanordnung, die beispielsweise in einen Brückenzweig einer Wheatstone'schen Brückenschaltung eines magnetoresistiven Sensorelementes integriert oder verschaltet ist und nach dem Spin-Valve-Prinzip arbeitet, durch lokales Erwärmen die Richtung des sogenannten "Exchange-Bias-Effektes", d.h. die Richtung der resultierenden Magnetisierung, einzustellen. Dabei sollte insbesondere ein Aufheizen der Schichtanordnung mit Hilfe von in dieser geführten elektrischen Strömen oder der Einsatz von Laserstrahlung vermieden werden.

### Vorteile der Erfindung

Das erfindungsgemäße Verfahren und der erfindungsgemäße Heizstempel hat gegenüber dem Stand der Technik den Vorteil, dass damit eine sehr einfache Einstellung oder lokale Veränderung einer resultierenden Magnetisierungsrichtung in einer Schicht einer magnetoresistiven Schichtanordnung mit einer ferromagnetischen Schicht und einer benachbarten anitferromagnetischen Schicht erfolgen kann, wobei die ferromagnetische Schicht eine resultierende Magnetisierungsrichtung mit einer zugeordneten, durch die antiferromagnetische Schicht induzierten oder beeinflussbaren, insbesondere stabilisierbaren, resultierenden Magnetisierungsrichtung aufweist.

Insbesondere erfordert das erfindungsgemäße Verfahren nicht das Vorsehen von zusätzlichen Strukturen innerhalb der magnetoresistiven Schichtanordnung, um diese gezielt lokal beheizen zu können, und der apparative Aufwand ist gegenüber der Bestrahlung mit Laserpulsen erheblich verringert. Daneben ist vorteilhaft, dass sich das erfindungsgemäße Verfahren und der erfindungsgemäße Heizstempel zur schnellen, großflächigen und gleichzeitigen Einstellung der resultierenden Magnetisierungsrichtung in einer Vielzahl von magnetoresistiven Schichtanordnungen eignet, die sich noch auf einem gemeinsamen Substrat befinden.

Insgesamt ist das erfindungsgemäße Verfahren gegenüber dem Stand der Technik einerseits deutlich schneller und andererseits kostengünstiger, da die Mehrkosten für die Herstellung einer zusätzlichen Schicht, die als Strombahn dienen kann, entfallen oder der ansonsten erforderliche Zeitaufwand für ein lokales Aufheizen bzw. Einschreiben einer resultierenden Magnetisierungsrichtung mit Hilfe eines fokussierten Laserstrahls erheblich reduziert wird.

Vorteilhafte Weiterbildungen der Erfindung ergeben sich aus in den Unteransprüchen genannten Maßnahmen.

So ist besonders vorteilhaft, wenn das Aufheizen der Schicht durch berührungslose Annäherung des Heizstempels an die magnetoresistive Schichtanordnung erfolgt. Es sei jedoch betont, dass es auch möglich ist, das Aufheizen durch in Kontakt bringen des Stempels mit einer Schicht der magnetoresistiven Schichtanordnung, beispielsweise einer üblicherweise vorgesehenen Deckschicht, vorzunehmen. Das Abkühlen nach dem Aufheizen mit Hilfe des Heizstempels erfolgt vorteilhaft einfach durch Entfernen des Stempels oder alternativ durch Abkühlen des Stempels, was jedoch aufwändiger ist.

Vorteilhaft ist weiter, wenn das externe Magnetfeld bereits während des Aufheizens zumindest der antiferromagnetischen Schicht der magnetoresistiven Schichtanordnung über die Schwellentemperatur angelegt ist. Prinzipiell ist es jedoch auch ausreichend, wenn dieses Magnetfeld erst nach Erreichen der Schwellentemperatur bzw. deren Überschreiten angelegt wird.

Um die erreichte Einstellung oder lokale Veränderung der resultierenden Magnetisierungsrichtung während der Wärmebehandlung mit Hilfe des Heizstempels möglichst weitgehend und unverändert beizubehalten, ist weiterhin vorteilhaft, wenn das externe Magnetfeld nach dem Anlegen bis zum Abkühlen der Schicht oder Schichtanordnung unter die Schwellentemperatur aufrecht erhalten wird.

Ganz besonders vorteilhaft ist bei dem erfindungsgemäßen Verfahren, wenn mehrere magnetoresistive Schichtsysteme insbesondere auf einem gemeinsamen Substrat vorgesehen sind, die als lokal begrenzte Bereiche, beispielsweise als isolierte Fläche mit einer typischen Größe von 5 µm² bis 500 µm², als Streifen mit einer Breite 0,1 µm bis 100 µm und einer Länge von 50 µm bis 120 mm, oder als mäanderförmige Strukturen, die von derartigen Streifen gebildet werden, ausgeführt sind. In diesem Fall lassen sich diese verschiedenen magnetoresistiven Schichtsysteme mit Hilfe des beheizten Stempels entweder gleichzeitig über die Schwellentemperatur aufheizen oder, beispielsweise durch Verschieben des Stempels und gegebenenfalls Veränderung der Richtung des externen Magnetfeldes danach, nacheinander über die Schwellentemperatur aufheizen.

Daneben ist in diesem Zusammenhang vorteilhaft, wenn mit dem beheizten Stempel insbesondere zunächst lediglich ein Teil der magnetoresistiven Schichtsysteme über die Schwellentemperatur aufgeheizt wird, so dass in einem anderen Teil der magnetoresistiven Schichtsysteme die resultierende Magnetisierungsrichtung in der diesen jeweils zugeordneten Schicht von dem Aufheizen mit dem Stempel zumindest nahezu unbeeinflusst bleibt. Auf diese Weise kann gezielt lokal bei einer Vielzahl von magnetoresistiven Schichtanordnungen in einem Teil dieser Schichtanordnungen eine Einstellung oder Veränderung der Richtung der resultierenden Magnetisierung in der ersten ferromagnetischen Schicht, die zu der antiferromagnetischen Schicht benachbart ist, vorgenommen werden, während in einem anderen Teil dieser Schichtanordnungen keine oder zunächst noch keine Veränderung der Richtung der resultierenden Magnetisierung erfolgt.

Auf diese Weise ist es sehr einfach möglich, in einem ersten Teil der Mehrzahl der magnetoresistiven Schichtsysteme eine erste resultierende Magnetisierungsrichtung und in einem zweiten Teil dieser Mehrzahl der magnetoresistiven Schichtsysteme eine von der ersten resultierenden Magnetisierungsrichtung verschiedene, insbesondere senkrecht oder entgegengesetzt dazu orientierte zweite resultierende Magnetisierungsrichtung einzustellen.

Dies kann beispielsweise dadurch erreicht werden, dass zunächst alle magnetoresistiven Schichtanordnungen die gleiche Richtung der resultierenden Magnetisierungsrichtung aufweisen, die dann mit Hilfe des erfindungsgemäßen Verfahrens in einem Teil dieser magnetoresistiven Schichtanordnungen verändert wird, oder dass das erfindungsgemäße Verfahren für einen ersten Teil der magnetoresistiven Schichtanordnungen mit einem externen Magnetfeld mit einer ersten Richtung und danach für einen zweiten Teil der magnetoresistiven Schichtanordnung mit einem externen Magnetfeld mit zweiter, von der ersten Richtung verschiedenen Richtung des Magnetfeldes durchgeführt wird.

Der Heizstempel ist vorteilhaft in Form eines beheizten Grundkörpers mit mit dem Grundkörper verbundener Stempelstruktur ausgeführt, wobei die Stempelstruktur bevorzugt über den Grundkörper beheizt und hinsichtlich ihrer lateralen Dimension an die Dimension der aufzuheizenden magnetoresistiven Schichtanordnung angepasst oder dieser zumindest ähnlich ausgebildet ist. Weiter ist es mit dem Heizstempel auch sehr einfach möglich, beispielsweise gleichzeitig nebeneinander auf einem Heizstempel eine Mehrzahl von beheizbaren, mit dem Grundkörper verbundenen Stempelstrukturen einzusetzen, die gleich oder untereinander zumindest teilweise auch verschieden ausgebildet sind. Dabei sind die einzelnen Stempelstrukturen bevorzugt jeweils hinsichtlich ihrer Dimension an die mit dem Heizstempel aufzuheizenden magnetoresistiven Schichtanordnungen angepasst oder zumindest jeweils diesen ähnlich ausgebildet.

In der Regel weisen die Stempelstrukturen in Draufsicht von der Unterseite des Stempels zumindest näherungsweise die Form eines Quaders mit rechteckiger oder quadratischer Stirnseite auf, wobei die Stirnseite bevorzugt eine Fläche von 5 µm² bis 1cm², besonders vorteilhaft von 0,5 mm² bis 5 mm², einnimmt.

Weiter ist vorteilhaft, wenn die Stempelstrukturen über eine geeignete, diesen jeweils zugeordnete Heizung oder eine entsprechende Gliederung des Grundkörpers unabhängig voneinander und insbesondere auf unterschiedliche Temperaturen aufheizbar sind. In diesem Fall kann beispielsweise eine erste Gruppe von Stempelstrukturen vorgesehen sein, die auf eine erste Temperatur aufheizbar sind, und eine zweite Gruppe von Stempelstrukturen, die eine davon verschiedene, zweite Temperatur aufheizbar sind, wobei eine dieser Temperaturen bevorzugt etwas oberhalb der Schwellentemperatur und die andere bevorzugt etwas unterhalb der Schwellentemperatur liegt.

Diese Vorgehensweise vermeidet mechanische Spannung innerhalb der magnetoresistiven Schichtanordnung beim Aufheizen und führt zudem zu einer Zeitersparnis, da einerseits insgesamt mehr Wärme in die Schichtanordnung eingetragen wird, so dass die über die Schwellentemperatur aufzuheizenden Bereiche schneller aufgeheizt werden, und andererseits bereits eine Vorwärmung der Schichtanordnung, deren Richtung der resultierenden Magnetisierung in einem ersten Schritt noch nicht verändert wird, vorgenommen wird, bevor diese Bereiche dann mit dem Stempel über die Schwellentemperatur aufgeheizt werden, um dort ebenfalls eine Einstellung oder lokale Veränderung der Richtung der resultierenden Magnetisierung vorzunehmen.

Ganz besonders eignet sich das erfindungsgemäße Verfahren und der erfindungsgemäße Heizstempel zur Herstellung eines magnetoresistiven, nach dem Spin-Valve-Prinzip arbeitenden Schichtsystem, das eine Mehrzahl von magnetoresistiven Schichtanordnungen mit untereinander zumindest teilweise unterschiedlichen resultierenden Magnetisierungsrichtungen in der jeweils betreffenden Schicht ("Bias-Schicht") aufweist, wobei die magnetoresistive Schichtanordnung in Form von üblichen Wheatstone'schen Brückenschaltungen beispielsweise zu Drehzahlsensorelementen oder Winkelsensorelementen miteinander verschaltet sind. Insbesondere ist mit Hilfe des Heizstempels eine lokale Aufheizung einzelner Brückenzweige einer solchen Wheatstone-Brückenschaltung mit mehreren magnetoresistiven Schichtanordnungen möglich, wobei der Stempel nahe an den betreffenden Brückenzweig herangeführt oder mit diesem in Kontakt gebracht wird, so dass ein Wärmeübertrag durch Wärmestrahlung oder Wärmeleitung erfolgen kann, der für die lokale Erwärmung des betreffenden magnetoresistiven Schichtsystems bzw. Brückenzweigs sorgt. Dies erlaubt die Einstellung der resultierenden Magnetisierungsrichtung in der Bias-Schicht bereits auf Wafer-Ebene, d. h. vor einer Vereinzelung der einzelnen Schichtanordnungen bzw. Schichtsysteme. In diesem Fall können überdies auch mehrere, beispielsweise hinsichtlich der Anordnung, Dimensionierung und/oder Beheizung der Stempelstrukturen unterschiedliche Heizstempel eingesetzt werden , um damit nacheinander oder gleichzeitig insbesondere unterschiedlich strukturierte oder dimensionierte Schichtanordnungen noch auf Wafer-Ebene aufzuheizen.

### Zeichnung

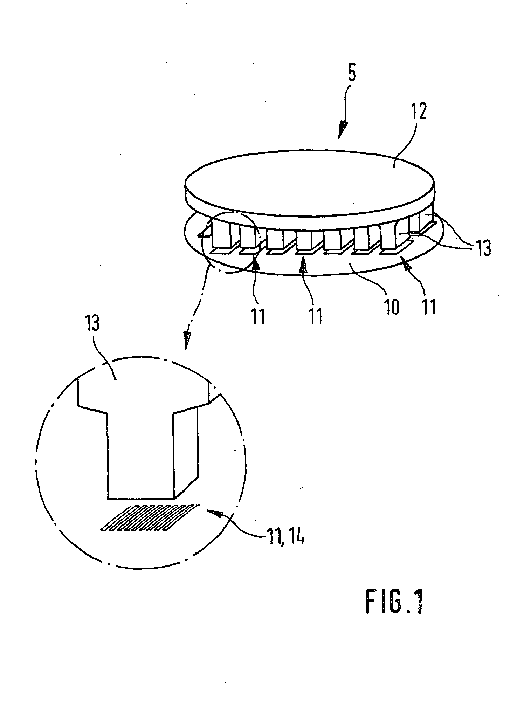

Die Erfindung wird anhand der Zeichnung und in der nachfolgenden Beschreibung näher erläutert. Es zeigt Figur 1 eine Prinzipsskizze eines vorderen Teils eines Heizstempels, der sich gegenüber einem Substrat befindet, wobei ein Ausschnitt aus dem Heizstempel im Bereich der Oberfläche des Substrats zusätzlich vergrößert dargestellt ist.

### Ausführungsbeispiele

Die Erfindung geht zunächst aus von einer magnetoresistiven Schichtanordnung aus, wie sie beispielsweise aus DE 198 43 348 A1 bekannt ist, so dass eine detaillierte Erläuterung von deren Funktion und Aufbau hier entbehrlich ist. Weiter sind hier mehrere, aus DE 198 43 348 A1 bekannte magnetoresistive Schichtanordnungen gemäß WO 00/79298 oder gemäß DE 198 30 344 A1 zu einem magnetoresistiven, nach dem Spin-Valve-Prinzip arbeitenden Schichtsystem in Form einer Wheatstone'schen Brückenschaltung zusammengeschaltet. Schließlich wird bei dem erfindungsgemäßen Verfahren weitgehend analog zu dem Verfahren gemäß DE 198 30 344 A1, WO 00/79298 A1 oder der unveröffentlichten Anmeldung DE 101 17 355.5-33 vorgegangen, wobei jedoch als wesentlicher Unterschied erfindungsgemäß mit einem Heizstempel bzw. einem beheizten Stempel anstelle von Strombahnen oder Laserpulsen gearbeitet wird.

Die Figur 1 zeigt dazu einen Heizstempel 5, der beispielsweise elektrisch beheizbar ist, und der einen Grundkörper 12, beispielsweise in Form einer metallischen Platte, und einer Vielzahl von mit dem Grundkörper 12 verbundenen beheizbaren Stempelstrukturen 13 aufweist. Diese sind im erläuterten Beispiel im wesentlichen quaderförmig ausgebildet und weisen eine typische Höhe von 1 mm bis 5 mm und eine Stirnfläche von beispielsweise jeweils 0,5 mm² bis 2 mm² auf. Der Heizstempel 5 befindet sich gemäß Figur 1 gegenüber einem Substrat 10, auf dem sich eine Vielzahl von magnetoresistiven Schichtanordnungen 11 erzeugt worden ist. Die Figur 1 zeigt somit auch das gleichzeitige Einstellen der sogenannten Exchange-Bias-Richtung auf bereits Wafer-Ebene bzw. Substratebene vor dem Vereinzeln. Im Übrigen sei noch erwähnt, dass während des erläuterten Einschaltens bzw. Aufheizens mit Hilfe des Heizstempels 5 in bekannter Weise ein externes Magnetfeld definierter Richtung angelegt wird. In Figur 1 ist schließlich auch ein Ausschnitt aus dem Heizstempel 5 im Bereich einer einzelnen Stempelstruktur 13 dargestellt, die sich gegenüber dem Substrat 10 befindet. Dabei ist auch die magnetoresistive Schichtanordnung 11 vergrößert dargestellt, sodass deren in Draufsicht mäanderförmige Struktur 14 erkennbar ist. Insgesamt ist der Heizstempel 5 in seiner Form so optimiert, dass er bei Annäherung an die mäanderförmige Struktur 14, die als Brückenzweig in einer Wheatstone'schen Brückenschaltung in einem magnetoresistiven, nach dem Spin-Valve-Prinzip arbeitenden Schichtsystem eingesetzt werden soll, diese lokal über eine materialspezifische Schwellentemperatur von beispielsweise 220°C ("Blocking-Temperatur") erwärmt.

## Patentansprüche

1. Verfahren zur Einstellung oder lokalen Veränderung einer resultierenden Magnetisierungsrichtung in einer Schicht einer magnetoresistiven Schichtanordnung (11) mit einer ferromagnetischen Schicht und einer benachbarten antiferromagnetischen Schicht, wobei die ferromagnetische Schicht eine resultierende Magnetisierung mit einer zugeordneten, durch die antiferromagnetische Schicht induzierten oder beeinflussbaren, insbesondere stabilisierbaren, resultierenden Magnetisierungsrichtung aufweist, **dadurch gekennzeichnet, dass** zumindest die antiferromagnetische Schicht mittels eines beheizten Stempels (5) über eine Schwellentemperatur aufgeheizt wird, oberhalb derer der Einfluss der antiferromagnetischen Schicht auf die resultierende Magnetisierungsrichtung der benachbarten ferromagnetischen Schicht zumindest weitgehend verschwindet, dass zumindest der der antiferromagnetischen Schicht benachbarte Bereich der ferromagnetischen Schicht einem externen Magnetfeld vorgegebener Richtung ausgesetzt wird, und dass danach die antiferromagnetische Schicht wieder unter die Schwellentemperatur abgekühlt wird.

2. Verfahren nach Anspruch 1, **dadurch gekennzeichnet, dass** das Abkühlen durch Entfernen oder Abkühlen des Stempels (5) und das Aufheizen durch berührungslose Annäherung des Stempels (5) an die magnetoresistive Schichtanordnung (11) oder in Kontakt bringen des Stempels (5) mit einer Schicht der magnetoresistiven Schichtanordnung (11) erfolgt.

3. Verfahren nach Anspruch 1 oder 2, **dadurch gekennzeichnet, dass** das externe Magnetfeld bereits beim Aufheizen auf die Schwellentemperatur oder erst nach deren Erreichen angelegt wird.

4. Verfahren nach einem der vorangehenden Ansprüche, **dadurch gekennzeichnet, dass** das externe Magnetfeld nach dem Anlegen bis zum Abkühlen unter die Schwellentemperatur aufrecht erhalten wird.

5. Verfahren nach einem der vorangehenden Ansprüche, **dadurch gekennzeichnet, dass** mehrere magnetoresistive Schichtsysteme (11), insbesondere auf einem gemeinsamen Substrat (10), vorgesehen sind, die als lokal begrenzte Bereiche, insbesondere isolierte Flächen einer Größe von 5 µm² bis 500 µm², Streifen einer Breite 0,5 µm bis 100 µm und einer Länge von 50 µm bis 120 mm, oder mäanderförmige Strukturen (14), die insbesondere derartige Streifen aufweisen oder daraus bestehen, ausgebildet sind, und dass mit dem Stempel (5) diese magnetoresistiven Schichtsysteme (11) zumindest teilweise nacheinander oder gleichzeitig über die Schwelltemperatur aufgeheizt werden.

6. Verfahren nach Anspruch 5, **dadurch gekennzeichnet, dass** lediglich ein Teil der magnetoresistiven Schichtsysteme (11) mit dem Stempel (5) über die Schwellentemperatur aufgeheizt wird, so dass insbesondere in einem anderen Teil der magnetoresistiven Schichtsysteme (11) die resultierende Magnetisierungsrichtung in der diesen jeweils zugeordneten Schicht vom dem Aufheizen mit dem Stempel zumindest nahezu unbeeinflusst bleibt.

7. Verfahren nach Anspruch 5 oder 6, **dadurch gekennzeichnet, dass** in den lokal begrenzten Bereichen eine Einstellung oder Veränderung der lokal dort jeweils resultierenden Magnetisierungsrichtung in der Schicht der magnetoresistiven Schichtanordnung (11) mit Hilfe des Stempels (5) derart vorgenommen wird, dass ein erster Teil der Mehrzahl der magnetoresistiven Schichtsysteme (11) in deren jeweiliger Schicht eine erste resultierende Magnetisierungsrichtung und ein zweiter Teil der Mehrzahl der magnetoresistiven Schichtsysteme (11) in deren jeweiliger Schicht eine von der ersten resultierenden Magnetisierungsrichtung verschiedene, insbesondere senkrecht oder entgegengesetzt dazu orientierte zweite resultierende Magnetisierungsrichtung aufweist.

8. Verfahren nach Anspruch 6 oder 7, **dadurch gekennzeichnet, dass** mit dem Stempel (5) zunächst lediglich der erste Teil der Schichtsysteme (11) über die Schwelltemperatur aufgeheizt wird, dass danach die Richtung des externen Magnetfeldes verändert wird, und dass danach mit dem Stempel (5) oder einem zweiten Stempel lediglich der zweite Teil der Schichtsysteme (11) über die Schwelltemperatur aufgeheizt wird.

9. Heizstempel zum Aufheizen einer magnetoresistiven Schichtanordnung (11) auf einem Substrat (10), mit einem Grundkörper (12) und einer beheizbaren, mit dem Grundkörper (12) verbundenen, an die magnetoresistive Schichtanordnung (11) hinsichtlich ihrer lateralen Dimension angepassten oder dieser ähnlichen Stempelstruktur (13).

10. Heizstempel nach Anspruch 9, **dadurch gekennzeichnet, dass** eine Mehrzahl von beheizbaren, mit dem Grundkörper (12) verbundenen, gleichen oder verschiedenen Stempelstrukturen (13) vorgesehen ist, wobei die Stempelstrukturen (13) jeweils einer oder mehreren magnetoresistiven Schichtanordnungen (11) zugeordnet und dazu hinsichtlich ihrer Dimension jeweils an diese Schichtanordnung (11) oder Gruppe von Schichtanordnungen (11) angepasst oder ähnlich ausgebildet sind.

11. Heizstempel nach Anspruch 9 oder 10, **dadurch gekennzeichnet, dass** die Stempelstruktur (13) zumindest näherungsweise die Form eines Quaders mit rechteckiger oder quadratischer Stirnseite mit einer Fläche von 5 µm² bis 1 cm², insbesondere 0,5 mm² bis 5 mm², aufweist.

12. Heizstempel nach einem der Ansprüche 9 bis 11, **dadurch gekennzeichnet, dass** die Stempelstrukturen (13) zumindest teilweise unabhängig voneinander, insbesondere auf unterschiedliche Temperaturen, beheizbar sind, oder dass eine erste Gruppe von Stempelstrukturen (13) und eine zweite Gruppe von Stempelstrukturen (13) vorgesehen ist, die auf unterschiedliche Temperaturen einstellbar sind.

13. Verwendung des Verfahrens oder des Heizstempels nach einem der vorangehenden Ansprüche zur Herstellung eines magnetoresistiven, nach dem Spin-Valve-Prinzip arbeitenden Schichtsystems, das eine Mehrzahl von magnetoresistiven Schichtanordnungen (11) mit untereinander zumindest teilweise unterschiedlichen resultierenden Magnetisierungsrichtungen in deren jeweiliger Schicht aufweist, wobei die magnetoresistiven Schichtanordnungen (11) insbesondere in Form einer Wheatstone-Brücke miteinander verschaltet sind.
